# EUROPÄISCHE PATENTSCHRIFT

(11) **EP 2 150 962 B1**
(45) Veröffentlichungstag und Bekanntmachung des Hinweises auf die Patenterteilung: **22.05.2013**
(21) Anmeldenummer: 08734465.1
(22) Anmeldetag: 05.04.2008
(51) Int. Cl.: H01B 13/012, G01R 31/00, G01R 31/02, G02B 6/44, H05K 13/06

(54) **KABELBAUMHERSTELLUNGSSYSTEM**
CABLE HARNESS PRODUCTION SYSTEM
SYSTÈME DE FABRICATION D'UN FAISCEAU DE CÂBLES

(30) Priorität: 25.05.2007 DE 102007024476
(43) Veröffentlichungstag der Anmeldung: 10.02.2010
(73) Patentinhaber: Selbach, Dirk, 97228 Rottendorf (DE)
(72) Erfinder: Selbach, Dirk, 97228 Rottendorf (DE)
(74) Vertreter: Pöhner, Wilfried Anton
(86) Internationale Anmeldenummer: PCT/DE2008/000578
(87) Internationale Veröffentlichungsnummer: WO 2008/145081

(56) Entgegenhaltungen:
- EP-A- 0 300 141
- WO-A1-98/16840
- DE-A1- 10 218 411
- JP-A- 63 286 701
- US-A- 3 633 096
- US-A- 4 218 745
- US-A- 5 535 788

## Beschreibung

Die Erfindung bezieht sich auf ein Kabelbaumherstellungssystem, bestehend aus einer elektronischen Steuerung und wenigstens einer Verlegeplatte, auf der mehrere Montagestationen befestigt sind, die jeweils entweder eine Aufnahme für ein direkt mit wenigstens einem Kabel des Kabelbaums verbundenes Funktionselement tragen oder als Kabelverlegehilfe, wie z.B. als Gabel, geformt sind, wobei wenigstens einer Montagestation wenigstens ein elektronischer Sender mit einem Prüfsensor zugeordnet ist, der durch die Montage eines Funktionselementes oder durch das Einlegen eines Kabels in die Kabelverlegehilfe aktivierbar ist, wobei eine Prüfmeldung als elektrische Welle absendbar und von der Steuerung empfangbar und auswertbar ist.

Ein Kabelbaum ist ein Strang von Kabeln, die Signale zur Information oder Ströme zur Energieversorgung übertragen. Unter dem Begriff "Kabel" sind hier mit Isolierstoff ummantelte Drähte aus Kupfer, Aluminium oder anderen Metallen ebenso zu verstehen, wie Koaxialkabel, Hohlwellenleiter und Lichtleitkabel wie z. B. Glasfaserkabel oder auch stahlverseilte Leiter. Die Kabel werden durch Schellen, Kabelbinder, Schläuche oder ähnliches zusammengehalten und der fertige Kabelbaum verbindet mehrere Funktionselemente wie Stecker, Verbinder, Schalter oder Leuchten miteinander. Oft ist die Form des Kabelbaums speziellen, räumlichen Erfordernissen beim Einbau anzupassen.

Vor allem im Automobilbau aber auch für elektrische Geräte werden zahlreiche Kabelbäume eingesetzt, die zum Beispiel in Kraftfahrzeugen nach aktuellem Stand der Technik Kabel mit einer Gesamtlänge von mehreren Kilometern enthalten können. Dabei ist durch mögliche Varianten der elektrischen Ausstattung auch für ansonsten gleiche Fahrzeuge oder gleiche Geräte eine Anzahl von verschiedenen Kabelbäumen erforderlich.

Die Kabel werden auf einer speziellen Werkbank oder auf einem Verlegebrett zu einem Kabelbaum zusammengesetzt, miteinander verklammert, umwickelt oder anderweitig mechanisch verbunden und an ihren Endpunkten mit den Funktionselementen elektrisch verbunden. Gemäß aktuellem Stand der Technik sind die Funktionselemente in den Aufnahmen von Montagestationen festgehalten und zur Führung und Abwinklung der Kabel sind Kabelverlegehilfen auf der Verlegeplatte angeordnet. Diese Verlegehilfen sind im einfachsten Fall Nägel, die zum Teil in die Verlegeplatte eingeschlagen sind, auf aktuellem Stand der Technik jedoch meist säulenartige Elemente, die eine Gabel oder einen Führungswinkel als Aufnahme tragen.

Nach aktuellem Stand der Technik existieren verschiedene Funktionselemente, die auf die Integration in einem Kabelbaum angepasst sind. So beschreibt z. B. US 5,945,635, Coutaro Suzuki, einen speziellen Kabelverbinder, der in Aufnahmen auf einer säulenartigen Montagestation ruht.

Der Grund für die erhöhte Anordnung der Funktionselemente ist, dass Werkzeuge zum Teil von mehreren Seiten des Funktionselementes angreifen müssen und dass die Kabelbäume mit Gewebeband umwickelt werden müssen oder Halteklemmen auf dem Kabelbaum aufzustecken sind.

Weitere, erforderliche Bearbeitungsschritte können das Einfädeln von Leitungen in Schläuche, das Anschlagen von Kontakten an die Leitungen, insbesondere die Verbindung von einem Kontakt mit zwei Leitungen und das Ineinanderstecken von Schläuchen sein. Jede dieser Bearbeitungsschritte erfordern zum Teil komplexe Bewegungsabläufe, bei denen sich zahlreiche Fehlermöglichkeiten auftun. Ein weiteres Risiko für Produktionsfehler ist die Komplexität der gesamten Struktur des Kabelbaumes.

Auch zur Reduzierung dieser Fehler liegt es nahe, die Verlegung der Kabel und ihre Verbindung mit den Funktionselementen zu automatisieren, also z. B. durch Roboter vornehmen zu lassen.

EP 0300141 beschreibt einen Industrieroboter, der auf einem Verlegebrett vollautomatisch Kabel verlegt und verbindet. Nachteilig ist jedoch der hohe Investitionsaufwand für den Roboter, seine Verbindung mit der Verlegeplatte und die laufende Neuprogrammierung für jeden einzelnen Kabelbaum und seine Varianten. Insbesondere für niedrige Stückzahlen und Einzelstücke von Kabelbäumen ist es deshalb nach wie vor wirtschaftlich sinnvoll, Kabelbäume auf Verlegebrettern mit entsprechenden Hilfseinrichtungen immer noch vorwiegend manuell zu produzieren.

Die hohe Komplexität der meisten Kabelbäume sowie die prinzipiell höhere Fehlerquote bei manueller Arbeit anstelle einer automatisierten bewirkt eine vergleichsweise hohe Fehlerquote bei der Kabelbaumfertigung. Deshalb ist nach aktuellem Stand der Technik eine Prüfung des fertigen Kabelbaums unerlässlich. Die dafür derzeit übliche Prüfanordnung sind auf der Rückseite der Verlegeplatte angeordnete Hilfskabel, über die ein Prüfgerät mit den Enden des soeben hergestellten Kabelbaums verbunden wird, wie u. a. EP 0 300 141 und DE 939 341, Ulrich Kölm, beschreiben.

Auch die US 5,535,788 beschreibt eine Verlegeplatte zur Herstellung von Kabelbäumen, die Aufnahmen für elektrische Funktionselemente enthält, die durch wenigstens einen Sensor in der Aufnahme mechanisch oder elektrisch überprüft werden können. Zur Übersendung der bei diesem Prüfvorgang ermittelten Ergebnisse wird die Aufnahmehalterung ebenso wie bei den zuvor genannten Dokumenten jeweils über ein zusätzliches Hilfskabel mit einer zentralen Steuerung verbunden.

Ein wesentlicher Nachteil ist, dass die Verlegung dieser Hilfskabel sehr zeitaufwändig ist und auch bei kleinen Änderungen oft nicht nur im Bereich der direkt davon betroffenen Hilfskabel Arbeiten erforderlich sind, sondern darüber hinaus auch noch bei anderen Hilfskabeln, die nach einer Verschiebung eines Teilbereichs zu Hindernissen werden und deshalb ebenfalls umzubauen sind. Daraus resultiert, dass in vielen Fällen das gesamte Verlegebrett neu aufgebaut werden muss.

Auf diesem Hintergrund hat sich die Erfindung die Aufgabe gestellt, Montagestationen für Kabelverlegesysteme zu schaffen, die schnell montiert und mit geringem Aufwand versetzt werden können und über einen Prüfsensor erfassbare Prüfergebnisse ohne den Aufwand eines zusätzlichen Hilfskabelbaums an eine übergeordnete Steuerung weitergeben können.

Als Lösung präsentiert die Erfindung ein Kabelbaumherstellungssystem mit den im Anspruch 1 angegebenen Merkmalen.

Das erfindungsgemäße Kabelbaumherstellungssystem ist nicht nur für alle Arten von Elektrokabeln geeignet, sondern auch für Lichtleiter und alle anderen, zumindest teilweise flexiblen Schläuche oder Rohre für Gase und Flüssigkeiten.

Der Kern der Erfindung ist die Kombination eines Prüfsensors für die Durchführung einer Prüfung am Kabelbaum mit anschließender Weiterleitung des Ergebnisses an einen elektronischen Sender, der die Information an eine Empfangseinheit in der zentralen Steuereinheit weiterreicht. Dabei sind Prüfsensoren für die verschiedensten Prüfgrößen in den verschiedensten Ausführungen anwendbar. Eine wichtige Gruppe der Prüfung betrifft mechanische Merkmale.

Dabei erfolgt die Übertragung der Informationen an die Steuerung über Funksignale. Die Erzeugung der hierzu erforderlichen Energie geschieht am Ort der Montagestation entweder über einen elektrischen Generator oder unter Zuhilfenahme von Solarmodulen. Der elektrische Generator erzeugt die Energie durch mechanische Aktivierung, den die Bewegung eines Funktionselementes bei seiner Montage oder die Bewegung eines Kabels beim Einlegen erzeugt. Dafür kann z.B. der beim Einlegen eines Funktionselementes heruntergedrückte Stift genutzt werden. Wenn darauf z.B. ein Permanentmagnet befestigt ist, oder dicht an einer Spule entlang geführt wird, induziert das magnetische Feld in der elektrischen Spule einen Strom, der direkt in den elektronischen Sender eingespeist werden kann. Dieses Signal ist sowohl der Befehl zum Beginn des Sendens als auch die einzuspeisende Energie. In einer Alternativen erfolgt die Energieversorgung über ein Solarmodul, das keine große Fläche benötigt, da es nur die zur Übermittlung einer Information erforderliche geringe Energiemenge bereitzustellen hat.

Der entscheidende Vorteil ist, dass überhaupt keine elektrische Verbindung zwischen Montagestation und Steuerung erforderlich sind. Die Montagestation kann also z.B. auf einer Holz- oder Kunststoffplatte an einem beliebigen Ort aufgeschraubt werden. Bei einem Versetzen der Montagestationen in einem existierenden Kabelbaumherstellungssystem muss lediglich die mechanische Befestigung gelöst und wieder neu hergestellt werden, was den Planungs- und Umrüstungsaufwand erheblich reduziert.

Als Prüfsensoren sind z.B. mechanische Schalter, induktive oder kapazitive Näherungsinitiatoren oder Gabellichtschranken geeignet.

Ein sehr einfaches Merkmal ist das Vorhandensein eines Funktionselementes oder eines Kabels. Denkbar sind aber auch die Überprüfung des jeweiligen Typs über spezielle Schlüsseldefinitionen oder die Überprüfung bestimmter Abmessungen. Denkbar ist z. B. dass ein unzulässig großer Kabelbaum mit nicht ausreichend dicht aneinander gelegten Kabeln in eine Zentrierung auf einer Montagestation eingelegt wird und dort durch seine Übergröße einen mechanischen Sensor aktiviert, der die Meldung "Übergröße" über seinen zugehörigen elektronischen Sender an die Steuerung weiterreichen kann.

Wenn z. B. geprüft werden soll, ob in einer Aufnahme tatsächlich ein Funktionselement eingelegt worden ist oder ob sich in einer Kabelverlegehilfe tatsächlich ein Kabel befindet, könnte dazu ein Stift dienen, der gegen die Kraft einer Feder durch das Einlegen eines Funktionselements in eine Aufnahme oder das Einlegen eines Kabels in eine Kabelverlegehilfe heruntergedrückt wird und dadurch ausgelöst wird. Der Stift müsste also in die Aufnahme oder in die Kabelverlegehilfe eingebaut werden und zwar so, dass er im unbelegten Zustand aus einer Fläche herausragt, auf welche sich beim Einlegen das Funktionselement bzw. das Kabel legt. Dieser Stift löst also immer dann eine Meldung aus, wenn er niedergedrückt wird.

Um nicht nur zu prüfen, das etwas eingelegt worden ist, sondern auch zu überwachen, was eingelegt worden ist, kann der Stift anstatt an der Montagestation am Funktionselement angebracht werden, so dass er beim Auflegen des Funktionselements auf die Montagestation durch eine Öffnung in der Aufnahme hindurch auf den Prüfsensor geschoben wird.

Diese Prüfung setzt voraus, dass jedes Funktionselement grundsätzlich mit einem entsprechenden Stift ausgerüstet ist, hat jedoch den großen Vorteil, dass versehentliche oder vorsätzliche Falschmeldungen nur mit erhöhtem Aufwand und einem zusätzlichen Werkzeug auslösbar sind, sowie dass eine Positivmeldung nicht durch irgendein Funktionselement, sondern nur durch dasjenige mit dem korrekten Stift ausgelöst wird.

Falls mehrere Funktionselemente mit gleichem Stift voneinander unterschieden werden sollen, kann der Stift ähnlich wie ein mechanischer Schlüssel profiliert sein und die Öffnung in der Aufnahme komplementär zu diesem Profil geformt werden. Dann ist nur das Einstecken eines passenden Profils möglich und "falsche" Funktionselemente, deren Stift ein anderes Profil aufweisen, werden zurückgewiesen.

Eine andere Ausführungsvariante für eine Kodierung der Stifte an den Funktionselementen ist die Anordnung der Öffnung für den Stift innerhalb der Aufnahme. Dazu sollte die Aufnahme Sinnvollerweise eine Zentrierung oder zumindest einen Rahmen aufweisen, welcher das Funktionselement in eine ganz bestimmte Position in Verhältnis zur Aufnahme führt. Dann kann die Öffnung für den Stift jeweils an einer anderen Stelle angeordnet werden, abhängig vom Typ des jeweils benötigten Funktionselements. In dieser Ausführungsvariante kann ein für diese Montagesituation nicht vorgesehenes Funktionselement nicht einmal eingerastet werden. Zusätzlich wird die Meldung einer korrekten Bestückung ausbleiben.

In einer anderen Ausführungsvariante kann die Aufnahme mit einem Öffnungsraster versehen werden, so dass jedes Funktionselement, das in die Aufnahme passt, auch eingerastet werden kann. Jedoch ist nur eine einzige der Öffnungen mit einem Prüfsensor versehen. Nur dann wenn ein Funktionselement eingeführt wird, dass einen Stift für diese Öffnung aufweist, wird die Positivmeldung einer Bestückung erfolgen. Der Vorteil dieser Anordnung ist eine vereinfachte Produktion der Montagestation als ein Standardteil, das nur durch Verschieben des Prüfsensors auf die Erfordernisse eines bestimmten Platzes auf dem Verlegebrett angepasst wird.

Ein weiterer, durch einen geeigneten Prüfsensor überprüfbarer Bereich sind optische Merkmale. Dafür kann der Prüfsensor z. B. eine Farbkamera oder ein anderes Farberkennungsgerät sein. Damit kann geprüft werden, ob an einer bestimmten Stelle ein Kabel mit der vorgesehenen Farbe eingebaut ist oder ein am Kabel befestigtes Element wie ein Stecker, ein Kabelclip oder ein Wickelband.

Eine elektrisch auslösbare Ausführungsform eines erfindungsgemäßen Kabelbauinherstellungssystems ermöglicht die Überprüfung elektrischer Merkmale durch den Prüfsensor. Wenn der Prüfsensor z. B. aus zwei elektrischen Kontakten besteht, die sehr nahe beieinander angeordnet sind, dann kann durch die Berührung dieser beiden Kontakte von einem abisolierten Ende eines Kabels überprüft werden, ob ein elektrisch leitfähiges Teil vorhanden ist, indem ein Strom von dem einen elektrischen Kontakt über das berührte Ende des Kabels in den anderen elektrischen Kontakt fließt. Damit könnte z. B. das Vorhandensein eines metallischen Steckkontaktes oder die erfolgreiche Isolationsentfernung eines Kabelendes nachgewiesen werden.

Als eine weitere, sehr interessante Ausführungsform schlägt die Erfindung vor, dass ein gesamter Strang des Kabelbaums geprüft wird. Dazu wird je ein Prüfsensor an beiden Enden des zu prüfenden Kabels benötigt. Jeder Prüfsensor weist einen elektrischen Kontakt auf, über den er mit dem jeweiligen Kabelende elektrisch leitend verbunden ist. Um einen Stromkreis schließen zu können, benötigt die Verlegeplatte in dieser Ausführungsform zumindest eine elektrisch leitfähige Beschichtung oder ist im Ganzen elektrisch leitend. Zusätzlich müssen die Montagestationen an beiden Enden des zu prüfenden Kabels über elektrisch leitfähige Elemente mit der leitfähigen Schicht auf der Verlegeplatte verbunden sein.

Unter diesen Voraussetzungen kann einer der beiden elektronischen Sender in den Montagestationen am Ende des Kabels einen Impuls oder ein anderes elektrischen Signal auslösen, das von einem Empfänger in der zweiten Montagestation empfangen werden kann, sofern tatsächlich eine leitfähige Verbindung zwischen den beiden Prüfsensoren über das Kabel besteht.

Zur Erleichterung des Verständnisses der Erfindung ist darauf hinzuweisen, dass im Stande der Technik die Verlegeplatte mit zwei elektrisch leitenden und voneinander isolierten Schichten versehen ist, die mit den beiden Polen einer elektrischen Versorgungsspannung verbunden sind. Jede Montagestation wird mit diesen beiden Schichten elektrisch leitend verbunden. Für diese Verbindung ist z. B. das Befestigungsmittel der Montagestation auf der Verlegeplatte geeignet. Eine sehr einfache Ausführungsform sind z. B. Schrauben, die sich mit scharfkantigen Gewinden in Materialien wie eine Spanplatte ohne Vorbohrung eindrehen lassen. Diese Schrauben können durch Metallfolien oder dünne Bleche innerhalb oder auf der Spanplatte hindurch gedrückt werden und bilden dabei eine elektrisch leitfähige Verbindung aus. Unabhängig vom physikalischen Verfahren der Weitergabe einer jeden Prüfmeldung empfängt die Steuerung die Meldungen von sämtlichen Montagestationen auf der Montageplatte gemeinsam. Um diese Meldungen einer bestimmten Montagestation zuzuordnen, muss jede Montagestation ihre Identifikation mit aussenden. Erst dann kann die Steuerung nicht nur erkennen, dass eine Prüfmeldung eintrifft, sondern von welcher Montagestation diese Meldung stammt. Mit dieser zusätzlichen Information kann die Steuerung überwachen, ob im jeweiligen Schritt der Fertigung des Kabelbaums die gerade empfangene Prüfmeldung überhaupt erwünscht ist und sie dann anschließend dem Prüfbericht korrekt zuzuordnen.

Da jede Montagestation in einer Fertigungseinrichtung eine eigene Identität hat und diese bei jeder Prüfmeldung dem Empfänger in der zugehörigen elektronischen Steuerung mitteilt, bietet sich dadurch auch die Möglichkeit, bei mehreren Verlegeplatten in einer Serienfertigung mit mehreren, verschiedenen Bearbeitungsplätzen, von denen jeder eine eigene Steuerung hat, das jeweilige Verlegebrett anhand der Identitäten der darauf befindlichen Montagestationen zu identifizieren, sofern den Steuerungen bekannt ist, welche Montagestationen auf welchem Verlegebrett montiert worden sind.

Die Prüfmeldung selbst kann im einfachsten Fall ein binäres Signal sein, dass dann als "Vorhanden/Nicht vorhanden" zu interpretieren ist. Es ist jedoch auch möglich, eine weiter differenzierte Prüfung durchzuführen und das Ergebnis als Prüfmeldung zu übersenden, wie z. B. die Größe eines Widerstands.

In der Steuerung ist die Auswertung mehrerer, eintreffender Prüfmeldungen so lange unkritisch, wie sicher ist, dass alle Prüfmeldung in wenigstens einem geringen zeitlichen Abstand zueinander eintreffen. Sobald jedoch zwei Prüfmeldungen zum gleichen Zeitpunkt empfangen werden können, sind Fehlinterpretationen möglich. Das kann z. B. bei der automatisierten Bearbeitung eines Verlegebrettes durch zwei Roboter vorkommen. In diesem Fall ist die Nutzung eines üblichen Bus-Protokolls, wie z. B. Can oder Sercos, sinnvoll. Die dafür benötigten elektronischen Bauteile werden millionenfach genutzt und sind daher zu geringen Kosten und mit hoher Zuverlässigkeit verfügbar.

In einer weiteren, vorteilhaften Ausführungsvariante ist der elektronische Sender auch zum Empfang von Signalen aus der Steuerung geeignet. In dieser Ausführungsvariante kann die Steuerung an jede damit ausgerüstete Montagestation Meldungen absetzen, die dort optische und/oder akustische und/oder mechanische Meldungen aktivieren. Mögliche Melder auf der Montagestation sind z. B. eine LED, ein numerisches Display, ein alphanumerisches Display, ein Summer oder eine mechanisch ausklappbare Meldefläche. Damit kann die Steuerung z.B. der Arbeitskraft, die den Kabelbaum manuell herstellt, Informationen und Anweisungen übermitteln, welche Montagestation als nächste zu bearbeiten ist, welches Funktionselement darauf liegen soll oder wie ein Kabel von einer Montagestation zu einer anderen über mehrere Kabelverlegehilfen hinweg zu verlegen ist.

Als weitere Funktion wurde bereits der Befehl erwähnt, das von einer Montagestation ein Prüfstrom über ein Kabel des Kabelbaumes an eine andere Montagestation fließen soll. Damit kann im einfachsten Fall das Vorhandensein und das Funktionieren einer elektrischen Verbindung geprüft werden. Denkbar ist jedoch auch ein Betriebstest eines elektrischen Funktionselementes und dessen Verkabelung.

Im Folgenden sollen weitere Einzelheiten und Merkmale der Erfindung anhand von Beispielen näher erläutert werden. Diese sollen die Erfindung jedoch nicht einschränken, sondern nur erläutern.

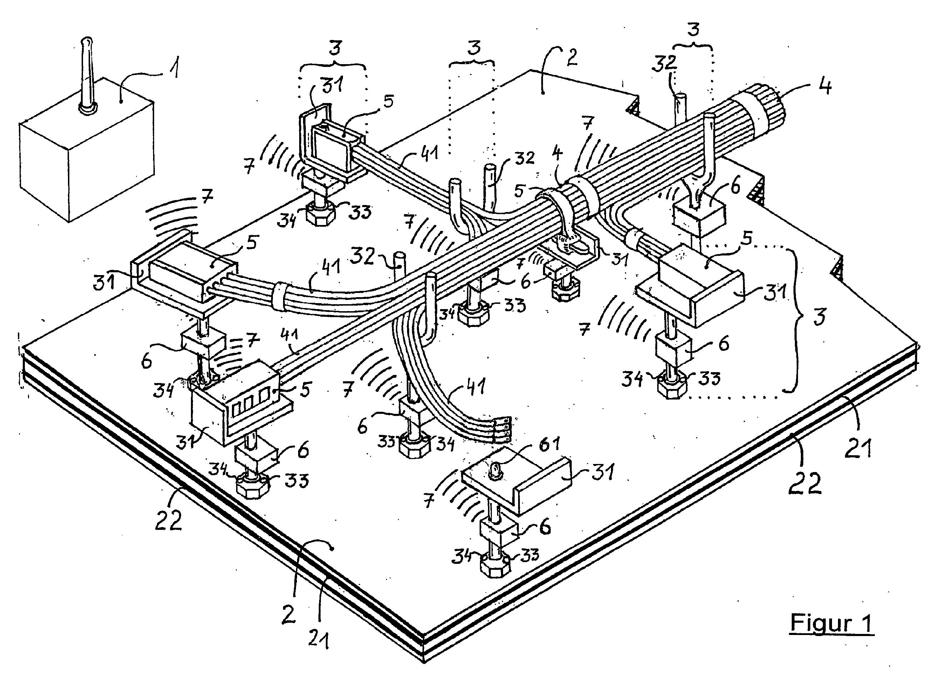

Es zeigt in schematischer Darstellung die **Figur 1** die perspektivische Darstellung eines Ausschnittes aus einer Verlegeplatte 2 mit insgesamt neun Montagestationen 3, von denen drei Stück in Bildmitte sowie am rechten Rand jeweils eine Kabelverlegehilfe 32 tragen, die im hier dargestellten Beispiel als U-förmige Gabel geformt ist. Die anderen sechs Montagestationen 3 tragen jeweils eine Aufnahme 31, die Platz für ein Funktionselement 5 am Ende wenigstens eines Kabel 41 vom Kabelbaum 4 bietet.

Im dargestellten Ausführungsbeispiel trägt nur die Aufnahme 31 an der unteren, vorderen Ecke des dargestellten Teils der Verlegeplatte 2 noch kein Funktionselement 5. Dadurch wird der Prüfsensor 61 sichtbar, in diesem Ausführungsbeispiel ein Stift, der gegen die Kraft einer Feder vom Funktionselement 5 niedergedrückt wird, wenn es auf die Auflage 31 gelegt wird.

Etwa in Bildmitte zwischen den drei U-förmigen Gabeln ist eine Montagestation 3 dargestellt, die auf ihrer Aufnahme 31 ein Funktionselement 5 trägt, das als Kabelclip ausgebildet ist. Es besteht aus einem Band, das um den Kabelbaum herumgeführt ist und im Schlitz eines Verbindungsblockes zu einem Ring geschlossen ist. Der Verbindungsblock ist mit einem (hier nicht sichtbaren) Widerhakenstift in eine Öffnung in der Aufnahme 31 eingesteckt. Darin prüft ein (hier ebenfalls nicht sichtbarer) Prüfsensor 61 das Vorhandensein des Widerhakenstiftes und damit des Funktionselementes.

Für alle neun dargestellten Montagestationen 3 ist der jeweils eigene Sender 6 im Fuße zu erkennen. Durch konzentrische Kreissegmente sind die elektrischen Wellen symbolisiert, die der Sender 6 abstrahlt, um die Prüfmeldung 7 an den Empfangsbaustein in der Steuerung 1 weiterzugeben. Die Prüfmeldung 7 ist das Ergebnis der Prüfung, welche durch den Prüfsensor 61 durchgeführt worden ist. Für die Montagestation 3 vorne in der Mitte, auf die noch kein Funktionselement 5 aufgelegt ist, ist diese Prüfmeldung 7also im dargestellten Bearbeitungsstadium negativ.

Als Alternative zur Energieversorgung jedes einzelnen Senders 6 weist in der dargestellten Ausführungsform der Fuß jeder Montagestation 3 zwei Bohrungen auf, durch welche hindurch eine erste Schraube 33 und eine zweite Schraube 34 die Montagestation 3 auf der Verlegeplatte 2 fixiert. Im dargestellten Beispiel ist die Verlegeplatte 2 mit einer ersten, elektrisch leitenden Schicht 21 nahe der Oberseite sowie einer zweiten, elektrisch leitenden Schicht 22 nahe der Unterseite versehen. Der Teil der Platte zwischen diesen beiden elektrisch leitenden Schichten muss als Isolator wirken.

An der Schnittkante der Verlegeplatte 2 ist leicht nachvollziehbar, dass die erste Schraube 33 nur so kurz sein darf, dass sie die erste leitende Schicht 21 sicher durchdringt, sodass ein elektrischer Kontakt zwischen dieser Schicht und der ersten Schraube 33 hergestellt wird aber nicht so lang, dass sie einen Kontakt mit der zweiten, leitenden Schicht 22 hat. Die zweite Schraube 34 muss dann so lang sein, dass sie die zweite leitende Schicht 22 sicher durchbricht, aber nicht so lang, dass sie ohne Not auf der rückwärtigen Seite der Platte wieder weit austritt.

Damit die zweite, längere Schraube 34 nicht einen Kurzschluss zwischen der ersten (21) und der zweiten elektrisch leitenden Schicht 22 verursacht, muss der obere Teil ihres Schaftes mit einem isolierenden Abstandshalter versehen sein, sodass sie beim Erreichen der zweiten leitenden Schicht 22 keinen elektrischen Kontakt zur ersten leitenden Schicht 21 mehr hat.

Alternativ kann in der ersten, leitenden Schicht 21 auch eine Bohrung vorgestanzt werden, durch welche die Schraube 34 hindurch geführt wird, ohne die obere leitende Schicht 21 zu kontaktieren. Sinnvollerweise sollten diese Bohrungen in einem Raster auf der Platte angeordnet werden, sodass alle gewünschten Positionen zumindest annäherungsweise mit der Genauigkeit des Rasters erreichbar sind.

Als ein Beispiel für die Funktion eines erfindungsgemäßen Kabelbaumherstellungssystems ist auf der vordersten Aufnahme 31 noch kein Funktionselement 5 aufgelegt. Die dort hinführenden Kabel 41 des Kabelbaums 4 enden in vier Flachsteckern, die noch frei in den Raum hängen und auf den Kontakt zum noch fehlenden Funktionselement 5 warten. Ebenso wartet - wie erwähnt - der Prüfsensor 61 auf dieses Funktionselement 5.

In Figur 1 wird nachvollziehbar, dass im dargestellten Ausführungsbeispiel und in dessen dargestelltem Bestückungsstand von den acht gezeichneten Montagestationen 3 fast alle eine positive Meldung abgeben, wohingegen die als vorderste dargestellte Aufnahmestation 31 mangels eines darauf liegenden Funktionselementes 5 eine Negativmeldung abzugeben hat.

In Figur 1 ist leicht nachvollziehbar, dass der Kabelbaum 4 in einem Abstand zur Verlegeplatte 2 verläuft, sodass er an vier Stellen mit einem Band umwickelt werden kann.

In diesem Fall wandelt jeder elektronische Sender 6 die Prüfmeldung in ein elektrisches Signal um, dass auf einer Trägerfrequenz aufmoduliert wird, die von allen anderen Montagestationen sowie von der Steuerung empfangen werden kann. Nur in der Steuerung werden die darin enthaltene Informationen dekodiert und verarbeitet.

Das Ausführungsbeispiel von Figur 1 zeigt also eine Energieversorgung jeder Montagestation 3 über eine Einspeisung an die beiden elektrisch leitenden Schichten 21 und 22 der Verlegeplatte 2, die jeweils mit der kurzen Schraube 33 und der langen Schraube 34 verbunden sind, welche über ihre metallisch leitenden Aufnahmebohrungen den elektrischen Strom weiter in den Fuß der Montagestation 3 bis zum elektronischen Sender 6 führen.

In Figur 1 wird leicht nachvollziehbar, dass jede Montagestation 3 eine eigene Identität haben muss, um eine zweifelsfreie Zuordnung zwischen einer abgestrahlten Prüfmeldung 7 und der befallenen Stelle herstellen zu können.

### Bezugszeichenliste

| | |
|---|---|
| 1 | elektronische Steuerung |
| 2 | Verlegeplatte |
| 21 | erste, elektrisch leitende Schicht der Verlegeplatte 2 |
| 22 | zweite, elektrisch leitende Schicht der Verlegeplatte 2 |
| 3 | Montagestation, auf Verlegeplatte 2 |
| 31 | Aufnahme für einen Funktionselement 5 als Teil der Montagestation 3 |
| 32 | Kabelverlegehilfe als Teil der Montagestation 3 |
| 33 | erste Schraube zur Befestigung der Montagestation 3 auf der Verlegeplatte 2 |
| 34 | zweite Schraube zur Befestigung der Montagestation 3 auf der Verlegeplatte 2 länger wie die erste Schraube 33 |
| 4 | Kabelbaum, zur Befestigung der Montagestation 3 auf der Verlegeplatte 2 |
| 41 | Kabel, Teil des Kabelbaumes 4, durch Kabelverlegehilfe 32 geführt |
| 5 | Funktionselement, am Ende eines Kabels 41 und auf einer Aufnahme 31 |
| 6 | Sender, elektronisch, in Montagestation 3 |
| 61 | Prüfsensor, in Montagestation 3, verbunden mit Sender 6 |
| 7 | Prüfmeldung, vom Prüfsensor 61 erfasst und vom Sender 6 abgesandt |

## Patentansprüche

1. Kabelbaumherstellungssystem bestehend aus einer elektronischen Steuerung (1) und wenigstens einer Verlegeplatte (2), auf der mehrere Montagestationen (3) befestigt sind, die jeweils
- entweder eine Aufnahme (31) für ein direkt mit wenigstens einem Kabel (41) des Kabelbaums (4) verbundenes Funktionselement (5) tragen
- oder als Kabelverlegehilfe (32), wie z.B. als Gabel, geformt sind,
wobei
wenigstens einer Montagestation (3) wenigstens ein elektronischer Sender (6) mit einem Prüfsensor (61) zugeordnet ist,
- der durch die Montage eines Funktionselementes (5) oder durch das Einlegen eines Kabels (41) in die Kabelverlegehilfe (32) aktivierbar ist,
- wobei eine Prüfmeldung (7) als elektrische Welle absendbar und von der Steuerung (1) empfangbar und auswertbar ist,
**dadurch gekennzeichnet,**
**dass** die Prüfmeldung (7) als eine elektrische Welle abgestrahlt wird,
deren Frequenz so hoch ist, dass sie sich als Funksignal drahtlos bis Steuerung
zur Steuerung (1) ausbreitet und dass in dieser wenigstens einen Montagestation (3) entweder
die Energie zur Versorgung des elektronischen Senders (6) durch einen elektrischen Generator erzeugbar ist, der mechanisch durch die Bewegung eines Funktionselementes (5) bei seiner Montage oder die Bewegung eines Kabels beim Einlegen aktivierbar ist
oder
zur Energieversorgung ein Solarmodul in wenigstens diese eine Montagestation (3) integriert ist.

2. Kabelbaumherstellungssystem nach dem vorhergehenden Anspruch,
**dadurch gekennzeichnet, dass** das Funktionselement (5) ein Stecker oder
ein Verbinder oder
ein Schalter oder
eine Leuchte oder
ein Sensor oder
eine Elektronikbaugruppe oder eine Kabelhalterung oder
ein Kabelclips oder
eine Kabelbefestigung oder eine Kabelschelle oder
ein Kabelverbinder oder
eine Kabelführung oder
eine Kabeltülle oder
ein Schlauch oder
ein Wickelband oder
eine Kabeldurchführung oder
eine Boxenplombe oder
eine Durchziehplombe oder
eine Kabelmarkierung
ist.

3. Kabelbaumherstellungssystem nach dem vorhergehenden Anspruch 1 **dadurch gekennzeichnet, dass** der Prüfsensor (61) mechanisch auslösbar ist.

4. Kabelbaumherstellungssystem nach dem vorhergehenden Anspruch 3, **dadurch gekennzeichnet, dass** der Prüfsensor (61)
- ein mechanischer Schalter oder
- ein induktiver Näherungsinitiator oder
- ein kapazitiver Näherungsinitiator oder
- eine Gabellichtschranke ist.

5. Kabelbaumherstellungssystem nach dem vorhergehenden Anspruch 3, **dadurch gekennzeichnet, dass** der Prüfsensor (61) durch wenigstens einen Stift auslösbar ist, der gegen die Kraft einer Feder durch das Einlegen eines Funktionselementes (5) in eine Aufnahme (31) oder das Einlegen eines Kabels (41) in eine Kabelverlegehilfe (5) auslösbar ist.

6. Kabelbaumherstellungssystem nach dem vorhergehenden Anspruch 3, **dadurch gekennzeichnet, dass** ein Stift am Funktionselement (5) angebracht ist und durch eine Öffnung in der Aufnahme (31) hindurch auf den Prüfsensor (61) schiebbar ist.

7. Kabelbaumherstellungssystem nach dem vorhergehenden Anspruch 5, **dadurch gekennzeichnet, dass** der Stift profiliert ist und die Öffnung in der Aufnahme (31) komplementär zu diesem Profil geformt ist.

8. Kabelbaumherstellungssystem nach den vorhergehenden Ansprüchen 5 bis 6, **dadurch gekennzeichnet, dass** mehrere Montagestationen (3) eine gleiche Aufnahme (31) aufweisen, in der die Öffnung für den Stift jeweils an einer anderen Stelle angeordnet ist, abhängig vom Typ des jeweils benötigten Funktionselementes (5).

9. Kabelbaumherstellungssystem nach dem vorhergehenden Anspruch 8, **dadurch gekennzeichnet, dass** die Aufnahme (31) ein Öffnungsraster aufweist und der Prüfsensor (61) hinter einer dieser Öffnungen angebracht ist, abhängig vom Typ des für diese Montagestation vorgesehenen Funktionselementes (5).

10. Kabelbaumherstellungssystem nach einem der vorhergehenden Ansprüche, **dadurch gekennzeichnet, dass** der Prüfsensor (61) optisch auslösbar ist.

11. Kabelbaumherstellungssystem nach dem vorhergehenden Anspruch 10, **dadurch gekennzeichnet, dass** der Prüfsensor (61) eine Farbkamera oder ein anderes Farberkennungsgerät ist.

12. Kabelbaumherstellungssystem nach einem der vorhergehenden Ansprüche **dadurch gekennzeichnet, dass** der Prüfsensor (61) elektrisch auslösbar ist.

13. Kabelbaumherstellungssystem nach dem vorhergehenden Anspruch 12, **dadurch gekennzeichnet, dass** der Prüfsensor (61) zwei elektrische Kontakte aufweist.

14. Kabelbaumherstellungssystem nach dem vorhergehenden Anspruch 12, **dadurch gekennzeichnet, dass**
- ein erster Prüfsensor (61) einen elektrischen Kontakt aufweist, der mit dem einen Ende des Kabels (41) elektrisch leitend verbunden ist und
- das andere Ende des Kabels (41) mit dem elektrischen Kontakt eines zweiten Prüfsensors (61) verbunden ist und
- beide Prüfsensoren (61) über den jeweils zugeordneten, elektronischen Sender (6), die jeweilige Montagestation (3) und eine elektrisch leitfähige Schicht auf der Verlegeplatte (2) miteinander verbunden sind und
- ein von dem ersten elektronischen Sender (6) ausgelöster, elektrischer Impuls von einem Empfänger im zweiten elektronischen Sender (6) empfangbar ist, sofern eine elektrische leitende Verbindung über den ersten Prüfsensor (61), das Kabel (41) und den zweiten Prüfsensor (61) besteht.

15. Kabelbaumherstellungssystem nach einem der vorhergehenden Ansprüche **dadurch gekennzeichnet, dass** zusammen mit der Prüfmeldung (7) eine Identifikation der jeweiligen Montagestation (3) mit sendbar ist.

16. Kabelbaumherstellungssystem nach einem der vorhergehenden Ansprüche **dadurch gekennzeichnet, dass** die Prüfmeldung (7) eine binäre Meldung ist.

17. Kabelbaumherstellungssystem nach einem der vorhergehenden Ansprüche **dadurch gekennzeichnet, dass** der Betrag des Prüfergebnisses von der Prüfmeldung (7) in mehreren Stufen übermittelbar ist.

18. Kabelbaumherstellungssystem nach einem der vorhergehenden Ansprüche **dadurch gekennzeichnet, dass** der elektronische Sender (6) auch zum Empfang von Signalen aus der Steuerung (1) geeignet its.

19. Kabelbaumherstellungssystem nach dem vorhergehenden Anspruch 18, **dadurch gekennzeichnet, dass** vom elektronischen Sender (6) ein optischer und/oder akustischer und/oder mechanischer Melder auf der Montagestation (3) aktivierbar ist.

20. Kabelbaumherstellungssystem nach dem vorhergehenden Anspruch 19, **dadurch gekennzeichnet, dass** der Melder auf der Montagestation (3)
- eine LED und/oder
- ein numerisches Display und/oder
- ein alphanumerisches Display und/oder
- ein Summer und/oder
- eine ausklappbare Meldefläche ist.

## Claims

1. Cable harness production system comprising an electronic controller (1) and at least one installation plate (2), to which a plurality of mounting stations (3) are fastened, which in each case
- either support a receptacle (31) for a functional element (5), which is directly connected to at least one cable (41) of the cable harness 4,
- or are shaped as a cable installation aid 32, for example, as a fork,
wherein
to at least one mounting station (3), at least one electronic transmitter (6) with a test sensor 61 is assigned,
- which can be activated by the mounting of a functional element (5) or by the insertion of a cable (41) into the cable installation aid (32),
- wherein a test message (7) as an electric wave can be emitted and
can be received by the controller (1) and can be evaluated, **characterised in that**
the test message (7) is emitted as an electrical wave whose frequency is so high that it propagates wirelessly as a radio signal as far as the controller (1), and **in that**, in this at least one mounting station (3), either
the energy for supplying the electronic transmitter (6) can be generated by an electrical generator, which can be activated mechanically by the movement of a functional element (5) during its mounting or by the movement of a cable during insertion or
a solar module is integrated into at least this one mounting station (3) for energy supply.

2. Cable harness production system according to the preceding claim, **characterised in that** the functional element (5) is a plug or
a connector or
a switch or
a lamp or
a sensor or
an electronic module or
a cable holder or
a cable clip or
a cable fastener or
a cable clamp or
a cable connector or
a cable guide or
a cable bushing or
a flexible tube or
a winding tape or
a cable gland or
a pull-through seal or
a cable marker.

3. Cable harness production system according to the preceding claim 1, **characterized in that** the test sensor (61) can be mechanically triggered.

4. Cable harness production system according to the preceding claim 3, **characterized in that** the test sensor (61) is
- a mechanical switch or
- an inductive proximity initiator or
- a capacitive proximity initiator or
- a forked light barrier.

5. Cable harness production system according to the preceding claim (3), **characterized in that** the test sensor (61) can be triggered by at least one pin, which can be triggered against the force of a spring by the insertion of a functional element (5) into a receptacle (31) or the insertion of a cable (41) into a cable installation aid (5).

6. Cable harness production system according to the preceding claim 3, **characterized in that** a pin is mounted on the functional element (5) and can be pushed through an opening in the receptacle (31) onto the test sensor (61).

7. Cable harness production system according to the preceding claim 5, **characterized in that** the pin is profiled and the opening in the receptacle (31) is shaped so as to be complementary to this profile.

8. Cable harness system according to the preceding claims 5 to 6, **characterised in that** a plurality of mounting stations (3) have an identical receptacle (31), in which the opening for the pin is arranged in a different place in each case, depending on the type of the functional element (5) that is required in each case.

9. Cable harness system according to the preceding claim 8, **characterised in that** the receptacle (31) has an opening grid and the test sensor (61) is mounted behind these openings, depending on the type of the functional element (5) that is provided for this mounting station.

10. Cable harness production system according to one of the preceding claims, **characterised in that** the test sensor (61) can be optically triggered.

11. Vehicle impact sensor according to the preceding claim 10, **characterised in that** the test sensor (61) is a colour camera or another colour recognition device.

12. Cable harness production system according to one of the preceding claims, **characterised in that** the test sensor (61) can be electrically triggered.

13. Cable harness production system according to the preceding claim 12, **characterised in that** the test sensor (61) has two electrical contacts.

14. Cable harness production system according to the preceding claim 12, **characterised in that**
- a first test sensor (61) has an electrical contact, via which it is electrically connected to one end of the cable (41) and
- the other end of the cable 41 is connected to the electrical contact of a second test sensor 61 and
- both test sensors (61) are connected together via electronic transmitters (6) that are respectively assigned to them, the respective mounting station (3) and an electrically conductive layer on the installation plate (2), and
- an electrical pulse initiated by the first electronic transmitter (6) can be received by a receiver in the second electronic transmitter (6), in so far as an electrical connection exists via the first test sensor (61), the cable (41) and the second test sensor (61).

15. Cable harness system according to one of the preceding claims, **characterised in that**, together with the test message (7), an ID of the respective mounting station (3) can be transmitted as well.

16. Cable harness production system according to one of the preceding claims, **characterised in that** the test message (7) is a binary message.

17. Cable harness production system according to one of the preceding claims, **characterised in that** the value of the test result can be transmitted by the test message (7) in a plurality of stages.

18. Cable harness production system according to one of the preceding claims, **characterised in that** the electronic transmitter (6) is also suitable for receiving signals from the controller (1).

19. Cable harness system according to the preceding claim 18, **characterised in that** the electronic transmitter (6) can activate an optical and/or acoustic and/or mechanical detector on the mounting station (3).

20. Cable harness system according to the preceding claim 19, **characterised in that** the detector on the mounting station (3) is
- an LED and/or
- a numeric display and/or
- an alphanumeric display and/or
- a buzzer and/or
- a fold-out message surface.

## Revendications

1. Système de fabrication de faisceau de câbles consistant en une commande électronique (1) et au moins une plaque de pose (2) qui sont fixées sur plusieurs postes de montage (3), chacune
• portant une réception (31) pour un élément fonctionnel (5) relié directement avec au moins un câble (41) du faisceau de câbles (4)
• ou bien sont formées en tant qu'aide à la pose de câble (32), comme par exemple une fourche
sachant que
au moins un poste de montage (3) est attribué à au moins un émetteur électronique (6) avec un capteur de test,
• qui peut être activé par le montage d'un élément fonctionnel (5) ou par la pose d'un câble (41) dans l'aide à la pose de câble (32),
• sachant qu'un message de contact (7) peut être émis sous la forme d'une onde électrique et peut être reçu et évalué par la commande (1)
**caractérisé par le fait**
• **que** le message de test (7) peut être émis sous la forme d'une onde électrique dont la fréquence est si élevée qu'elle se répand en tant que signal radio sans fil jusqu'à la commande (1), et que dans cette dernière, dans au moins un poste de montage (3), l'énergie destinée à alimenter l'émetteur électronique peut être générée par un générateur électrique qui peut être activé mécaniquement par le mouvement d'un élément fonctionnel (5) lors de son montage ou du déplacement d'un câble lors de la pose de ce dernier
ou bien
**qu'**un module solaire destiné à l'alimentation en énergie est intégré dans au moins ce poste de montage (3).

2. Système de fabrication de faisceau de câbles selon la revendication précédente, **caractérisé par le fait que** l'élément fonctionnel (5) est
une fiche ou
un connecteur ou
un interrupteur ou
une lampe ou
un capteur ou
un sous-ensemble électronique ou
un support de câble ou
un clip de câble ou
une fixation de câble ou
un collier de câble ou
un connecteur de câble
un guidage de câble ou
un tissu de câble ou
un flexible ou
une bande enrouleuse ou
un passage de câble ou
un plomb de boite ou
un plomb de tirage ou
un repère de câble.

3. Système de fabrication de faisceau de câbles selon la revendication précédente, **caractérisé par le fait que** le capteur de test (61) peut être déclenché mécaniquement.

4. Système de fabrication de faisceau de câbles selon la revendication précédente, **caractérisé par le fait que** le capteur de test (61) est
• un interrupteur mécanique ou
• un initiateur inductif de proximité ou
• un initiateur capacitif de proximité ou
• une barrière lumineuse à fourche

5. Système de fabrication de faisceau de câbles selon la revendication précédente, **caractérisé par le fait que** le capteur de test (61) peut être déclenché par au moins une goupille pouvant être déclenchée contre la force d'un ressort par l'insertion d'un élément fonctionnel (5) dans une réception (31) ou l'insertion d'un câble (41) dans une aide à la pose de câble (5).

6. Système de fabrication de faisceau de câbles selon la revendication 3, **caractérisé par le fait qu'**une goupille est disposée sur l'élément fonctionnel (5) en pouvant être poussée sur le capteur de test (61) à travers une ouverture dans la réception (31).

7. Système de fabrication de faisceau de câbles selon la revendication précédente, **caractérisé par le fait que** la goupille est profilée et que l'ouverture dans la réception (31) est formée de façon complémentaire à ce profil.

8. Système de fabrication de faisceau de câbles selon la revendication 5 à 6, **caractérisé par le fait que** plusieurs postes de montage (3) présentent une même réception (31) dans laquelle l'ouverture de la goupille est disposée à chaque fois à un autre endroit, en fonction du type d'élément fonctionnel (5) dont on a à chaque fois besoin.

9. Système de fabrication de faisceau de câbles selon la revendication précédente 8, **caractérisé par le fait que** la réception (31) présente une trame d'ouverture et que le capteur de test (61) est disposé derrière ces ouvertures, en fonction du type de l'élément fonctionnel (5) prévu pour ce poste de montage.

10. Système de fabrication de faisceau de câbles selon une des revendications précédentes, **caractérisé par le fait que** le capteur de test (61) peut être déclenché optiquement.

11. Système de fabrication de faisceau de câbles selon la revendication précédente 10, **caractérisé par le fait que** le capteur de test (61) est une caméra couleur ou un autre appareil de détection de couleur.

12. Système de fabrication de faisceau de câbles selon la revendication précédente 10, **caractérisé par le fait que** le capteur de test (61) peut être déclenché électriquement.

13. Système de fabrication de faisceau de câbles selon la revendication précédente 12, **caractérisé par le fait que** le capteur de test (61) présente deux contacts électriques.

14. Système de fabrication de faisceau de câbles selon la revendication précédente 12, **caractérisé par le fait que**
• un premier capteur de test (61) présente un contact électrique qui est relié à une extrémité du câble (41) en étant conducteur électriquement
• l'autre extrémité du câble (41) est reliée au contact électrique d'un deuxième capteur de test (61),
• les deux capteurs de test (61), étant reliés l'un avec l'autre par l'intermédiaire de l'émetteur électronique (6) attribué à chaque fois, le poste de montage respectif (3) et une couche électriquement conductrice sur la plaque de pose (2),
• une impulsion électrique déclenchée par le premier émetteur électronique (6) pouvant être réceptionné par un récepteur dans le deuxième émetteur électronique (6), pour autant qu'il y ait une liaison électriquement conductrice via le premier capteur de test (61), le câble (61) et le second capteur de test (61).

15. Système de fabrication de faisceau de câbles selon une des revendications précédentes, **caractérisé par le fait qu'**une identification de chaque poste de montage respectif (3) peut être envoyée en même temps que le message de test (7).

16. Système de fabrication de faisceau de câbles selon une des revendications précédentes, **caractérisé par le fait que** le message de test (7) est un message binaire.

17. Système de fabrication de faisceau de câbles selon une des revendications précédentes, **caractérisé par le fait que** le montant du résultat du test peut être transmis par le message de test (7) en plusieurs étapes.

18. Système de fabrication de faisceau de câbles selon une des revendications précédentes, **caractérisé par le fait que** le capteur électronique (6) convient également à la réception de signaux provenant de la commande (1).

19. Système de fabrication de faisceau de câbles selon la revendication précédente 18, **caractérisé par le fait qu'**un détecteur optique et/ou acoustique et/ou mécanique sur le poste de montage peut être activé par l'émetteur électronique (6).

20. Système de fabrication de faisceau de câbles selon la revendication précédente 19, **caractérisé par le fait que** le détecteur sur le poste de montage (3) est
• une LED et/ou
• un écran numérique et/ou
• un écran alphanumérique et/ou
• un vibreur et/ou
• une surface de signalement sortable.
